# EUROPÄISCHE PATENTSCHRIFT

(11) **EP 2 975 769 B1**
(45) Veröffentlichungstag und Bekanntmachung des Hinweises auf die Patenterteilung: **28.09.2016**
(21) Anmeldenummer: 15171441.7
(22) Anmeldetag: 10.06.2015
(51) Int. Cl.: H03K 17/94

(54) **OPTOELEKTRONISCHER SENSOR**
OPTOELECTRONIC SENSOR
CAPTEUR OPTOÉLECTRONIQUE

(30) Priorität: 18.07.2014 DE 102014110176
(43) Veröffentlichungstag der Anmeldung: 20.01.2016
(73) Patentinhaber: SICK AG, 79183 Waldkirch/Breisgau (DE)
(72) Erfinder: Merettig, Gerhard, 79350 Sexau (DE); Döbele, Christian, 79341 Kenzingen (DE); Bohli, Alexander, 79206 Breisach (DE); Weisenberger, Fabian, 79346 Endingen (DE)
(74) Vertreter: Manitz, Finsterwald & Partner GbR

(56) Entgegenhaltungen:
- DE-A1-102011 083 524
- DE-U1-202011 004 094
- JP-A- H11 126 549
- US-A1- 2013 113 465

## Beschreibung

Die vorliegende Erfindung betrifft einen optoelektronischen Sensor zur Erkennung von Objekten oder Objekteigenschaften, insbesondere einen Lichttaster, umfassend einen Lichtsender zum Aussenden von Sendelichtstrahlen in einen Beleuchtungsbereich, einen Lichtempfänger zum Empfangen von Empfangslichtstrahlen, und eine Auswerteeinheit, die dazu ausgebildet ist, anhand eines von dem Lichtempfänger ausgegebenen Empfängersignals ein in dem Beleuchtungsbereich befindliches oder in diesen hineinragendes Objekt zu erfassen und/oder eine Eigenschaft eines solchen Objekts zu ermitteln, wobei der Auswerteeinheit eine Einstellvorrichtung zum Einstellen eines die Auswertung betreffenden Referenzwerts wie eines Schaltschwellwerts zugeordnet ist, und wobei die Einstellvorrichtung ein drückbares Bedienelement umfasst, mit welchem der Referenzwert auf einen durch das aktuelle Empfängersignal vorgegebenen Einlernwert festlegbar ist.

Derartige Sensoren werden in vielfältiger Weise zum berührungslosen Detektieren von im Sichtbereich des Sensors vorhandenen Objekten eingesetzt. Beispielsweise dienen Lichttaster dazu, den Abstand einer Objektoberfläche von einer Bezugsebene des Sensors zu ermitteln. Mittels Lichtschranken oder Lichtgittern können z. B. in einen abgesicherten Bereich eindringende Personen erkannt werden. Ein weiteres Einsatzgebiet von optoelektronischen Sensoren ist die Ermittlung bestimmter Eigenschaften von Objekten, beispielsweise in Form einer Farberkennung oder des Identifizierens von objektseitigen Markierungen oder Kennzeichen.

Mittels der Einstellvorrichtung kann ein Benutzer einen Sensor der genannten Art an eine spezifische Anwendungssituation anpassen. Beispielsweise ist es bei Lichttastern für ein korrektes Funktionieren erforderlich, die Tastweite bzw. den Schaltabstand auf einen geeigneten Wert einzustellen. Der aktuell eingestellte Wert kann insbesondere in einer elektronischen Speichereinrichtung der Auswerteeinheit abgelegt sein.

Eine auf dem Gebiet der optoelektronischen Sensoren gebräuchliche Art der Referenzwerteinstellung ist das so genannte "Teachen" oder Einlernen, bei dem der Referenzwert z. B. per Tastendruck mit dem aktuellen Empfängersignal in Beziehung gesetzt und anschließend gespeichert wird.

Bei Sensoren, welche für ein Teachen ausgelegt sind, besteht das Problem, dass im Allgemeinen keine nachträgliche Feineinstellung möglich ist. Zudem kann ein Benutzer die aktuelle Einstellung am Sensor nicht erkennen.

Es sind auch Sensoren bekannt, die mit Drehpotentiometern zur kontinuierlichen Verstellung eines gespeicherten Referenzwerts ausgestattet sind. Eine Einstellung per Drehpotentiometer hat jedoch den Nachteil, dass sie aufgrund der Endanschläge nicht kompatibel mit einer zusätzlichen Einstellung über eine elektronische Schnittstelle ist. Außerdem ist für eine ausreichend feine Einstellung üblicherweise ein Mehrgangpotentiometer notwendig, das relativ kostspielig ist und dessen Betätigung aus Sicht mancher Benutzer lästig ist. Daher bieten Hersteller von optoelektronischen Sensoren oft bestimmte Sensortypen in zwei verschiedenen Varianten an - einer Teach-Variante und einer Potentiometer-Variante. Dies ist jedoch mit hohen Fertigungs- und Lagerkosten verbunden.

Die DE 20 2011 004 094 U1 offenbart eine Einstelleinheit für einen optischen Sensor, der sowohl mit einer Einlerntaste als auch mit einem Potentiometer ausgestattet ist. Es ist ein Bedienelement vorgesehen, mittels dessen sowohl die Taste als auch das Potentiometer betätigbar sind.

Die US 2013/113465 A1 offenbart einen sowohl drehbaren als auch drückbaren Einstellknopf, an dem ein Magnet befestigt ist. Mittels eines dreidimensionalen Hall-Sensors können die Bewegungen des Einstellknopfs ermittelt werden.

In der JP H11 126549 A ist ein Bedienelement für einen Detektor offenbart, das zum Verändern von angezeigten Parameterwerten drehbar und zum Abspeichern der gerade angezeigten Parameterwerte drückbar ist.

Es ist eine Aufgabe der Erfindung, einen optoelektronischen Sensor bereitzustellen, der kostengünstig und platzsparend ist und hinsichtlich der ReferenzwertEinstellung eine einfache Bedienbarkeit aufweist.

Die Lösung der Aufgabe erfolgt durch einen optoelektronischen Sensor mit den Merkmalen des Anspruchs 1.

Erfindungsgemäß umfasst die Einstellvorrichtung zusätzlich zu dem drückbaren Bedienelement ein um einen Drehwinkel von zumindest 360° drehbares Bedienelement sowie Mittel zum Erfassen der Drehstellung und der Drehstellungsänderung des drehbaren Bedienelements, wobei die Auswerteeinheit dazu ausgebildet ist, den Referenzwert in Abhängigkeit von der erfassten Drehstellung und/oder der erfassten Drehstellungsänderung anzupassen. Ein erfindungsgemäßer Sensor kann sowohl durch Teachen als auch durch Drehen an eine Anwendungssituation angepasst werden. Jeder Benutzer kann daher die von ihm bevorzugte Einstellvariante auswählen, sodass demgemäß die Anzahl der vorrätig zu haltenden Sensorbauteile reduziert ist. Außerdem kann bei Bedarf mittels Teachen eine schnelle Grobeinstellung und mittels Drehen eine nachträgliche Feineinstellung um den Teach-Wert herum vorgenommen werden, sodass insgesamt eine besonders schnelle und präzise Einstellung des Referenzwerts möglich ist.

Vorzugsweise ist das drehbare Bedienelement anschlagsfrei und/oder endlos drehbar. Dadurch wird die üblicherweise bei 270°-Potentiometern oder Mehrgang-Potentiometern bestehende Inkompatibilität mit einer zusätzlichen Referenzwertverstellung über eine externe elektronische Schnittstelle vermieden. Falls nämlich ein Potentiometer mit Endanschlägen verwendet wird, müsste nach jeder Referenzwert-Verstellung per Schnittstelle oder per Teach-Vorgang ein manuelles Nachstellen der Schleiferposition in Bezug auf die Endanschläge erfolgen, was nicht praktikabel ist.

Die Auswerteeinheit kann eine elektronische Speichereinrichtung zum Ablegen des Referenzwerts aufweisen. Beispielsweise kann die Speichereinrichtung als EEPROM-Baustein ausgeführt sein. In einem solchen, vorzugsweise nichtflüchtigen Speicher kann nicht nur der aktuelle Referenzwert gespeichert sein, sondern bei Bedarf auch die Drehstellung des drehbaren Bedienelements. Somit kann das drehbare Bedienelement in jeder Drehstellung mit dem aktuellen Referenzwert in Beziehung gesetzt werden. Das Auswerten ist somit nicht von der Absolutposition des drehbaren Bedienelements abhängig.

Die Auswerteeinheit kann dazu ausgebildet sein, den Referenzwert bei jeder Drehstellungsänderung des drehbaren Bedienelements zu erhöhen oder zu erniedrigen. Mit anderen Worten kann ein inkrementeller Betrieb des drehbaren Bedienelements vorgesehen sein. Das drehbare Bedienelement kann hierzu wiederholt oder kontinuierlich hinsichtlich einer Drehstellungsänderung überwacht werden. Eine inkrementelle, ausschließlich auf relativen Positionsänderungen beruhende Referenzwert-Anpassung ist mit weiteren Einstellmöglichkeiten besser vereinbar als eine Auswertung von Absolutpositionen.

Die Einstellvorrichtung kann ferner eine analoge oder digitale Schnittstelle zum zusätzlichen Anpassen des Referenzwerts anhand eines externen Einstellsignals umfassen. Eine solche Einstellmöglichkeit mittels Schnittstelle kann im Allgemeinen bei gleichzeitiger Verwendung eines 270°-Potentiometers oder eines Mehrgangpotentiometers nicht vorgesehen werden, da wie vorstehend erwähnt die Drehstellung des Schleifers in Bezug auf die zugehörigen Anschläge nach jeder über die Schnittstelle erfolgten Referenzwert-Verstellung nachgestellt werden müsste.

Gemäß einer speziellen Ausgestaltung der Erfindung ist die Auswerteeinheit dazu ausgebildet, nach jedem Drücken des drückbaren Bedienelements und gegebenenfalls nach jeder Änderung des Referenzwerts über eine Schnittstelle die aktuelle Drehstellung des drehbaren Bedienelements dem geänderten Referenzwert zuzuordnen. Das heißt die Verstellung des Referenzwerts mittels des drehbaren Bedienelements erfolgt stets ausgehend von dem zuletzt durch Teachen oder Schnittstellenbefehl festgelegten Wert. Auf diese Weise ist sichergestellt, dass stets der volle Verstellbereich des drehbaren Bedienelements zur Feineinstellung zur Verfügung steht.

Die Auswerteeinheit kann dazu ausgebildet sein, bei Erreichen einer Messbereichsgrenze des optoelektronischen Sensors das Anpassen des Referenzwerts zu stoppen, selbst wenn das drehbare Bedienelement weiter gedreht wird. Hierdurch kann der Verstellbereich begrenzt werden, ohne hierfür mechanische Anschläge vorsehen zu müssen, welche mit einer Schnittstellenverstellung unvereinbar sind.

Die Auswerteeinheit kann dazu ausgebildet sein, bei der Anpassung des Referenzwerts in Abhängigkeit von der erfassten Drehstellung und/oder Drehstellungsänderung die Einstellcharakteristik eines Standard-Potentiometers, insbesondere eines 270°-Potentiometers oder eines Mehrgang-Potentiometers, nachzubilden. Mit anderen Worten kann die Auswerteeinheit ein "virtuelles" Potentiometer bereitstellen. Dies ist in einfacher Weise dadurch möglich, dass bei der Auswertung ein geeigneter Umrechnungsfaktor zwischen der auf den Gesamtmessbereich bezogenen Wertänderung und dem überstrichenen Drehwinkel des drehbaren Bedienelements gewählt wird. Für den Benutzer kann die Wertänderung pro Umdrehung z.B. auf einer Anzeige erkennbar sein. Ein Vorteil der Nachbildung gängiger Potentiometer-Typen besteht darin, dass viele Benutzer die Bedienung solcher Standard-Potentiometer gewohnt sind und es daher schätzen, wenn ein anschlagsfreies drehbares Bedienelement die gleiche Einstellcharakteristik aufweist.

Das drehbare Bedienelement ist vorzugsweise als Drehpotentiometer ausgeführt. Die Auswerteeinheit kann hierzu über elektrische Leitungen und/oder Leiterplatten mit den Anschlusskontakten des Drehpotentiometers in Verbindung stehen. Dies ermöglicht eine besonders einfache und kostengünstige Herstellung. Grundsätzlich könnte anstelle eines Drehpotentiometers auch ein Hall-Sensor oder ein Drehwinkelgeber vorgesehen sein.

Vorzugsweise weist das Drehpotentiometer eine oder mehrere geschlossene Widerstandsbahnen auf. Im Gegensatz zu einer offenen, das heißt durch Anschläge auf beispielsweise 270° begrenzten Widerstandsbahn ermöglicht eine geschlossene Widerstandsbahn einen Rundum-Abgriff und demgemäß eine nicht durch Absolutwerte eingeschränkte Auswertung. Das Vorsehen von mehreren, z.B. konzentrischen geschlossenen Widerstandsbahnen ermöglicht außerdem einen Mehrfachabgriff, durch welchen erweiterte Auswertemöglichkeiten zur Verfügung stehen.

Gemäß einer Ausführungsform der Erfindung weist das Drehpotentiometer eine im Wesentlichen ringförmige Widerstandsbahn auf, die eine Unterbrechung aufweist, welche eine Breite von höchstens 5% des Bahnumfangs aufweist. Aufgrund der Unterbrechung kann bei der Auswertung zwischen denjenigen beiden Drehstellungen des Schleifers, die bei einer völlig geschlossenen Widerstandsbahn den gleichen Widerstandswert liefern würden, unterschieden werden. Da es sich jedoch lediglich um eine vergleichsweise schmale Unterbrechung handelt, kann der Schleifer problemlos über diese hinweg bewegt werden, sodass das Grundkonzept eines anschlagslos bzw. endlos betätigbaren Drehpotentiometers gewahrt bleibt.

Eine spezielle Ausgestaltung der Erfindung sieht vor, dass die Unterbrechung bezogen auf eine Radialrichtung schräg und/oder gekrümmt verläuft. Somit ist die Unterbrechung durch den Schleifer überbrückbar und es kann mittels einer Strommessung an einem der beiden Bahnkontakte festgestellt werden, ob sich der Schleifer im Bereich der Unterbrechung befindet.

Eine alternative Ausführungsform der Erfindung sieht vor, dass die Einstellvorrichtung einen mit dem Drehpotentiometer in Reihe schaltbaren Zusatzwiderstand aufweist, wobei die oder eine weitere Auswerteeinheit dazu ausgebildet ist, die Drehstellung eines Schleifers des Drehpotentiometers anhand eines Vergleichs einer Widerstandsmessung ohne Zusatzwiderstand und mit Zusatzwiderstand zu ermitteln. Durch die zusätzliche Messung mit Zusatzwiderstand kann die durch die geschlossene Widerstandsbahn bedingte Mehrdeutigkeit kompensiert werden. Bei einer solchen Ausgestaltung ist es nicht erforderlich, die Widerstandsbahn mit einer Unterbrechung zu versehen.

Das Drehpotentiometer kann einen ersten Schleifer und einen bezüglich des ersten Schleifers phasenversetzt angeordneten zweiten Schleifer aufweisen. Auf diese Weise kann dem beim Nulldurchgang auftretenden Sprung im Widerstandsverlauf entgegengewirkt werden.

Ferner kann das Drehpotentiometer wenigstens zwei teilweise umlaufende Widerstandsbahnen aufweisen, welche einander überlappen und so insgesamt einen Winkelbereich von 360° überdecken. Aufgrund der Überlappung ist sichergestellt, dass der gesamte Drehwinkelbereich abgedeckt ist und keine unerwünschten Sprünge im Widerstandsverlauf auftreten.

Gemäß einer weiteren Ausführungsform der Erfindung ist das drehbare Bedienelement als mechanischer Drehknopf ausgeführt, welcher mit einem Drehwinkelsensor, insbesondere einem Hall-Sensor oder einem Drehwinkelgeber, gekoppelt ist. Bei dieser Ausführungsform ist keine Bereitstellung eines Potentiometers erforderlich. Der Drehknopf kann mit einer Ausnehmung wie einem Schraubendreher-Schlitz und/oder mit einer Riffelung zur leichteren Bedienung versehen sein.

Das drückbare Bedienelement und das drehbare Bedienelement können als getrennte Bauteile ausgeführt sein, welche z. B. nebeneinander an einem Sensorgehäuse des optoelektronischen Sensors gelagert sind. Dies ermöglicht das Bereitstellen eines sowohl durch Teachen als auch durch Drehen bedienbaren Sensors unter Verwendung von kostengünstigen Standard-Bauteilen.

Es kann jedoch auch vorgesehen sein, dass das drückbare Bedienelement in das drehbare Bedienelement integriert ist oder umgekehrt. Mit anderen Worten kann ein und dasselbe Bedienelement sowohl zum Teachen als auch zum Drehen eingesetzt werden, was hinsichtlich der Herstellungskosten und des Platzbedarfs vorteilhaft ist.

Beispielsweise kann die Einstellvorrichtung einen Drehknopf aufweisen, welcher sowohl drehbar als auch bezüglich einer Drehachse axial verschiebbar in einem Gehäuse des optoelektronischen Sensors gelagert ist. Vorzugsweise ist hierbei vorgesehen, dass die Rotationsachse und die Verschiebeachse parallel zueinander verlaufen und insbesondere zusammenfallen. Hierdurch ergibt sich eine besonders kompakte Bauweise. Zudem ist es hinsichtlich der Bedienbarkeit vorteilhaft, wenn beide Betätigungsvarianten die gleiche "Bedienachse" aufweisen. Die Verschiebebewegung kann beispielsweise durch eine Gleitlagerung ermöglicht sein. Um einen Einsatz des Sensors in rauen Umgebungen zu ermöglichen, kann das Bedienelement durch eine Gleitdichtung gegenüber dem Gehäuse abgedichtet sein.

Es kann auch vorgesehen sein, dass das drehbare Bedienelement über ein Adapterbauteil mit einem Schleifer eines Drehpotentiometers gekoppelt ist und zwei an dem Adapterbauteil vorgesehene Kontakte, welche mit einer Einlernschaltung der Auswerteeinheit verbunden sind, durch eine Leiterfläche des drückbaren Bedienelements überbrückt sind, wenn sich das drückbare Bedienelement in einer gedrückten Endstellung befindet. Vorzugsweise ist eine hinsichtlich der Drehbewegung formschlüssige Kopplung zwischen dem Bedienelement oder dem Adapterbauteil einerseits und dem Schleifer andererseits vorgesehen, sodass bei einem Drehen des Bedienelements der Schleifer zuverlässig mitgenommen wird. Eine Rastverbindung erleichtert in diesem Zusammenhang die Montage. Durch die Überbrückung der Kontakte mittels des Adapterbauteils kann in einfacher Weise die Teach-Funktion bereitgestellt werden.

Bevorzugt ist das Adapterbauteil als Molded Interconnect Device (MID) ausgeführt. Bei der Fertigung derartiger Bauteile besteht eine besonders hohe Gestaltungsfreiheit. Zudem besteht die Möglichkeit, Mechanik-Komponenten und Leiterplatten in Kombination zu fertigen.

Bei einem erfindungsgemäßen Sensor kann eine Anzeige vorgesehen sein, welche die Lage des aktuellen Referenzwerts innerhalb eines Messbereichs des optoelektronischen Sensors kenntlich macht. Die Bedienung des Sensors ist hierdurch weiter vereinfacht. Insbesondere kann eine Balkenanzeige vorgesehen sein.

Weiterbildungen der Erfindung sind auch in den abhängigen Ansprüchen, der Beschreibung sowie der beigefügten Zeichnung angegeben.

Die Erfindung wird nachfolgend beispielhaft anhand der Zeichnung beschrieben.
- Fig. 1: ist eine schematische Darstellung eines erfindungsgemäßen optoelektronischen Sensors.
- Fig. 2: ist eine teilweise Explosionsdarstellung eines erfindungsgemäßen optoelektronischen Sensors.
- Fig. 3A: zeigt den Sensor gemäß Fig. 2 in zusammengesetztem Zustand und in einer perspektivischen Ansicht.
- Fig. 3B: zeigt den Sensor gemäß Fig. 2 in zusammengesetztem Zustand und in einer teilweise aufgeschnittenen perspektivischen Ansicht.
- Fig. 4: ist eine perspektivische Vorderansicht eines Adapterbauteils, das zur Kopplung eines Drehknopfs des in Fig. 3 gezeigten Sensors mit einem Drehpotentiometer vorgesehen ist.
- Fig. 5: zeigt das Adapterbauteil gemäß Fig. 4 von der Rückseite aus.
- Fig. 6: zeigt eine Einstellvorrichtung eines erfindungsgemäßen optoelektronischen Sensors.
- Fig. 7: zeigt die Einstellvorrichtung gemäß Fig. 6 in einer Explosionsdarstellung.
- Fig. 8: zeigt die Einstellvorrichtung gemäß Fig. 6 in einer Schnittansicht.
- Fig. 9: ist eine Teilschnittdarstellung eines optoelektronischen Sensors gemäß eines Beispiels.

- Fig. 10: zeigt den optoelektronischen Sensor gemäß Fig. 9 in einer Gesamtansicht.
- Fig. 11: ist eine schematische Darstellung des Einstellprinzips einer Einstellvorrichtung eines erfindungsgemäßen optoelektronischen Sensors.
- Fig. 12: ist eine vereinfachte Draufsicht auf ein Drehpotentiometer eines erfindungsgemäßen optoelektronischen Sensors.
- Fig. 13: ist eine vereinfachte Draufsicht auf ein Drehpotentiometer eines alternativ gestalteten erfindungsgemäßen optoelektronischen Sensors.
- Fig. 14: ist eine vereinfachte Draufsicht auf ein Drehpotentiometer eines weiteren alternativ gestalteten erfindungsgemäßen optoelektronischen Sensors.
- Fig. 15: ist eine vereinfachte Draufsicht auf ein Drehpotentiometer eines weiteren alternativ gestalteten erfindungsgemäßen optoelektronischen Sensors.
- Fig. 16: ist ein vereinfachtes Schaltbild einer Einstellvorrichtung eines erfindungsgemäßen optoelektronischen Sensors.
- Fig. 17: ist ein Diagramm, das die Schleiferspannung eines Drehpotentiometers eines erfindungsgemäßen optoelektronischen Sensors in Abhängigkeit von der Drehstellung eines Schleifers des Drehpotentiometers für verschiedene Messkonstellationen angibt.
- Fig. 18: ist ein Diagramm, das die mit Zusatzwiderstand ermittelte Schleiferspannung eines Drehpotentiometers eines erfindungsgemäßen optoelektronischen Sensors in Abhängigkeit von einer ohne Zusatzwiderstand ermittelten Schleiferspannung des Drehpotentiometers für verschiedene Messkonstellationen angibt.
- Fig. 19-22: zeigen verschiedene Ausführungsformen von Drehpotentiometern für den Einsatz in erfindungsgemäßen optoelektronischen Sensoren einschließlich der jeweiligen Widerstandsverläufe in Abhängigkeit von den Drehstellungen der jeweiligen Schleifer.

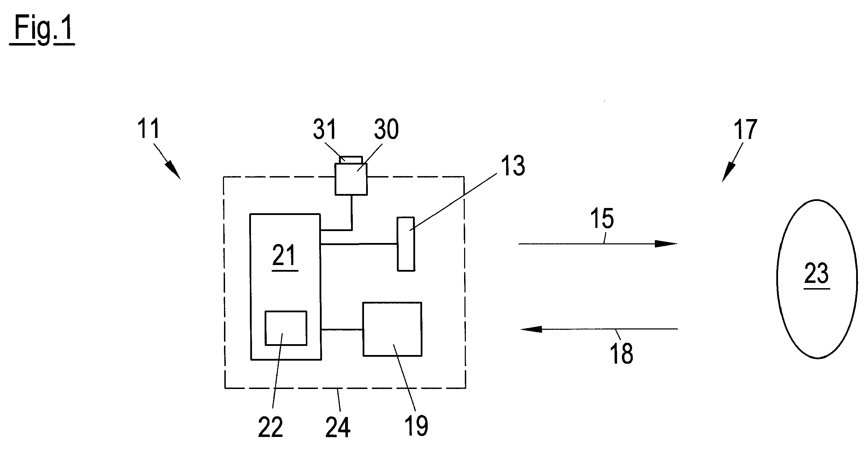

Der in Fig. 1 lediglich schematisch dargestellte optoelektronische Sensor 11, hier in der Ausgestaltung als Lichttaster, umfasst einen Lichtsender 13, welcher dazu ausgebildet ist, Sendelichtstrahlen 15 in einen Beleuchtungsbereich 17 auszusenden. Ein in dem Beleuchtungsbereich 17 vorhandenes Objekt 23 reflektiert oder remittiert die Sendelichtstrahlen 15, welche nachfolgend als Empfangslichtstrahlen 18 auf einen Lichtempfänger 19 des optischen Sensors 11 gelangen.

Eine elektronische Auswerteeinheit 21 steht mit dem Lichtempfänger 19 in Verbindung und ist in der Lage, anhand der von dem Lichtempfänger 19 empfangenen Empfangslichtstrahlen 18 das Objekt 23 zu erfassen und/oder eine Eigenschaft des Objekts 23 wie dessen Farbe zu ermitteln. Der Lichtsender 13 und der Lichtempfänger 19 sind in einem Sensorgehäuse 24 untergebracht.

Die Tastweite des Sensors 11 kann über eine Einstellvorrichtung 30 eingestellt werden, welche wenigstens ein am Sensorgehäuse 24 angeordnetes Bedienelement 31 umfasst und mit der Auswerteeinheit 21 in Verbindung steht. Anstelle der Tastweite könnte auch ein anderer die Auswertung betreffender Referenzwert mittels der Einstellvorrichtung 30 einstellbar sein. Der aktuelle Wert für die Tastweite ist in einem nichtflüchtigen Speicher 22 der Auswerteeinheit 21 abgelegt.

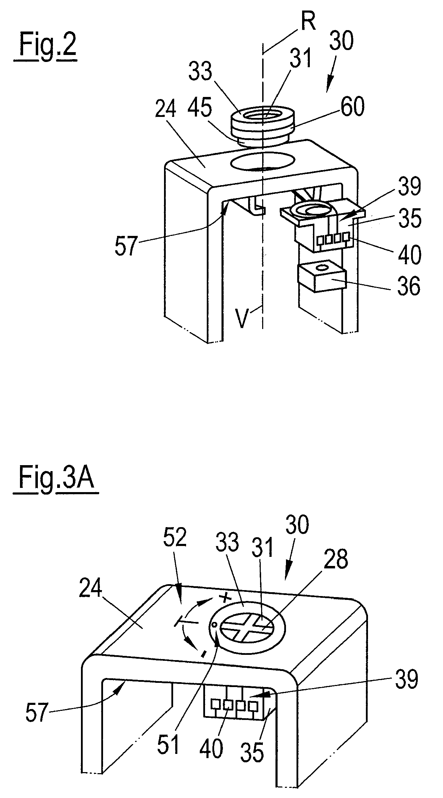

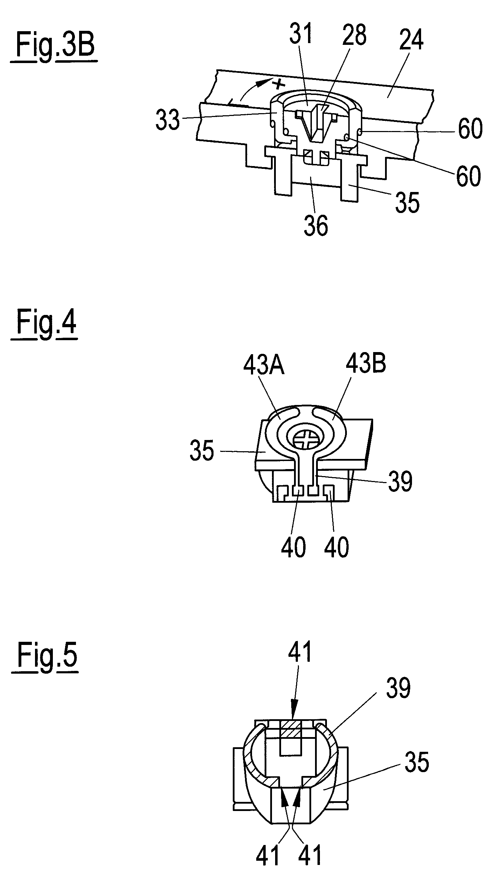

Fig. 2, 3A und 3B zeigen ein Ausführungsbeispiel der Einstellvorrichtung 30 im Detail, wobei in Fig. 2 der Deutlichkeit halber die einzelnen Bauteile voneinander beabstandet dargestellt sind. Bei diesem Beispiel ist ein Bedienelement 31 vorgesehen, welches mit einer Ausnehmung 28 (Fig. 3A) für einen Schraubendreher-Eingriff versehen ist und um eine Rotationsachse R drehbar ist. Ein ringförmiger Druckknopf 33, in dessen Zentrum das drehbare Bedienelement 31 angeordnet ist, ist entlang einer Verschiebeachse V verschiebbar in dem Sensorgehäuse 24 gelagert. Wie dargestellt fallen die Rotationsachse R und die Verschiebeachse V zusammen. Die Unterseite des Bedienelements 31 ist mit einem Adapterbauteil 35 gekoppelt, welches als MID-Bauteil gefertigt und im Sensorgehäuse 24 befestigt ist. Ein Drehpotentiometer 36 (Fig. 2) ist von unten in das Adapterbauteil 35 eingesteckt, wobei eine formschlüssige Kopplung zwischen dem drehbaren Bedienelement 31 und einem in Fig. 2, 3A und 3B nicht sichtbaren Schleifer des Drehpotentiometers 36 besteht. Bei einem Drehen des Bedienelements 31 wird somit das Drehpotentiometer 36 verstellt.

Das Drehpotentiometer 36 ist in grundsätzlich bekannter Weise mit der Auswerteeinheit 21 (Fig. 1) verbunden, welche ihrerseits dazu ausgebildet ist, den gespeicherten Wert für die Tastweite in Abhängigkeit vom veränderlichen Widerstandswert des Drehpotentiometers 36 anzupassen.

In Fig. 4 und 5 ist das Adapterbauteil 35 genauer dargestellt. Die elektrische Verbindung zwischen dem Drehpotentiometer 36 und der Auswerteeinheit 21 erfolgt über Leiterbahnen 39 und Kontaktstellen 40, welche auf das Adapterbauteil 35 aufgebracht sind und für eine Anbindung an weitere elektronische Komponenten, beispielsweise mittels Bonding, ausgelegt sind. An einer dem Druckknopf 33 zugewandten Vorderseite des Adapterbauteils 35 bilden zwei gegenüberliegende Verbindungsabschnitte 43A, 43B der Leiterbahnen 39 eine so genannte Teach-Geometrie, welche in grundsätzlich bekannter Weise mit einer Einlernschaltung oder Teach-Schaltung der Auswerteeinheit 21 in Verbindung steht. An der Rückseite des Adapterbauteils 35 sind Lötstellen 41 für eine Anbindung des Drehpotentiometers 36 vorgesehen.

Bei einem Drücken des Druckknopfs 33 wird dieser in Fig. 2 nach unten verschoben, wobei ein an der Unterseite des Druckknopfs 33 angeordnetes leitfähiges Element 45 (Fig. 2) die beiden Verbindungsabschnitte 43A, 43B überbrückt, das heißt kurzschließt. Infolge der Überbrückung sorgt die Einlernschaltung dafür, dass das aktuelle Empfängersignal mit einem vorgegebenen Faktor und gegebenenfalls mit einer vorgegebenen Funktion bewertet und als neuer Wert für die Tastweite gespeichert wird, wie dies grundsätzlich bekannt ist.

Im Ergebnis sind also sowohl das drehbare Bedienelement 31 durch Drehen als auch der Druckknopf 33 durch Drücken betätigbar und der in der Auswerteeinheit 21 gespeicherte Wert für die Tastweite kann dementsprechend wahlweise durch Teachen oder durch Drehen an eine spezielle Anwendungssituation angepasst werden. Grundsätzlich könnten auch der Druckknopf 33 und das drehbare Bedienelement 31 zu einem gemeinsam dreh- und drückbaren Bauteil kombiniert sein.

Durch geeignete Formschlusselemente (nicht dargestellt) am Bedienelement 31 und am Druckknopf 33 ist dafür gesorgt, dass ein Drücken des Druckknopfs 33, also das Durchführen eines Teach-Vorgangs, nur in einer bestimmten Drehstellung möglich ist. Aus der Darstellung gemäß Fig. 3A geht hervor, dass diejenige Drehstellung, in welcher ein Teach-Vorgang möglich ist, durch eine Markierung 51 und eine Beschriftung 52 kenntlich gemacht ist.

Bei der Montage der Einstellvorrichtung 30 wird das Drehpotentiometer 36 in das Adapterbauteil 35 gesteckt und verlötet. Anschließend wird das Adapterbauteil 35 an der Innenseite 57 des Sensorgehäuses 24 positioniert und gesichert. Durch ein verrastendes Einschnappen der von außen herangeführten vormontierten Anordnung aus Bedienelement 31 und Druckknopf 33 in das Adapterbauteil 35 werden die Bauteile formschlüssig miteinander verbunden. O-Ringe 60 (Fig. 2 und 3B) sorgen für eine Abdichtung des Bedienelements 31 gegenüber dem Druckknopf 33 sowie des Druckknopfs 33 gegenüber dem Sensorgehäuse 24. Bei Bedarf kann das Adapterbauteil 35 mit einem oder mehreren Anzeige-Elementen, z. B. Leuchtdioden, bestückt sein. Außerdem können der Druckknopf 33 und/oder das Bedienelement 31 wenigstens zum Teil transparent ausgeführt sein, sodass sie durch eine geeignete Lichtquelle zum Leuchten gebracht werden können.

Die auf das Adapterbauteil 35 aufgebrachten Anzeige-Elemente oder eine separate Anzeige können speziell dafür vorgesehen sein, die Lage des aktuellen Referenzwerts innerhalb eines Messbereichs des optoelektronischen Sensors 11 kenntlich zu machen.

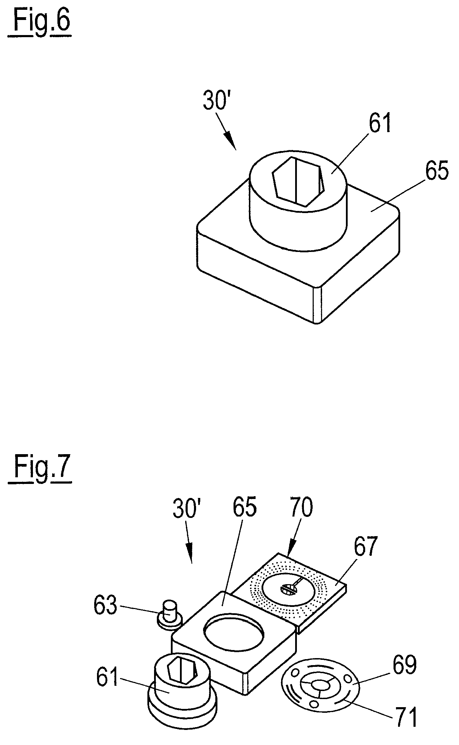

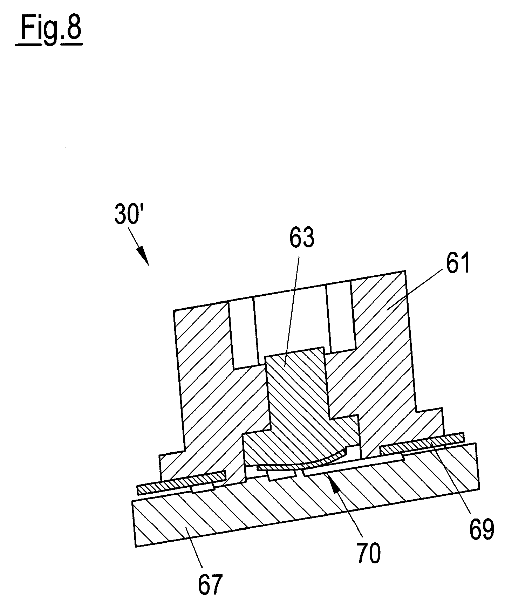

Fig. 6-8 zeigen eine alternative Ausführungsform einer Einstellvorrichtung 30' eines erfindungsgemäßen Sensors, welche einen Drehknopf 61, einen koaxial zu diesem angeordneten Tastknopf 63, eine Abdeckung 65, eine Leiterplatte 67 und einen leitfähigen, mit Aussparungen 71 versehenen Verbindungsring 69 umfasst. Eine Schleiferstruktur 70 ist direkt auf die Leiterplatte 67 aufgebracht. Wie aus Fig. 8 hervorgeht, wirken der Drehknopf 61 und der Tastknopf 63 über den Verbindungsring 69 mit der Schleiferstruktur 70 zusammen, um die Teach- und Drehverstell-Funktion bereitzustellen. Je nach Ausgestaltung der Schleiferstruktur 70 und des Verbindungsrings 69 kann die Einstellvorrichtung 30' hinsichtlich der Drehverstellung als inkrementeller Encoder oder als Potentiometer ausgeführt sein.

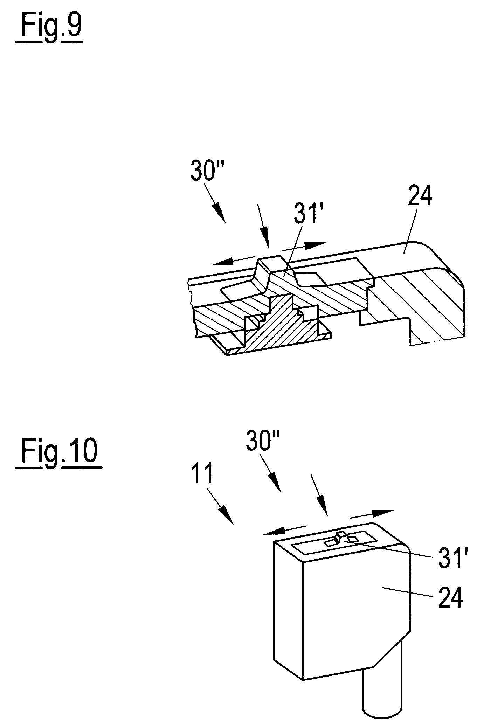

Ein alternatives Beispiel für die Einstellvorrichtung 30" ist in Fig. 9 und 10 gezeigt. Das Bedienelement 31' ist bei dieser Ausführungsform nicht drehbar, sondern wahlweise durch Drücken oder durch Verschieben quer zu der Drückrichtung betätigbar, wie in Fig. 9 durch Pfeile angegeben ist. Die Verschaltung der Einstellvorrichtung 30" ist derart, dass durch Drücken ein Teach-Vorgang erfolgt und durch das beidseitige Verschieben - ähnlich wie bei einer Wippe - eine Anpassung des Referenzwerts erfolgt, beispielsweise zur Feineinstellung nach einem Teachen.

Eine nicht dargestellte, alternative Ausführungsform der Erfindung sieht vor, dass die Einstellvorrichtung 30 ein drückbares Bedienelement und ein davon getrenntes drehbares Bedienelement aufweist.

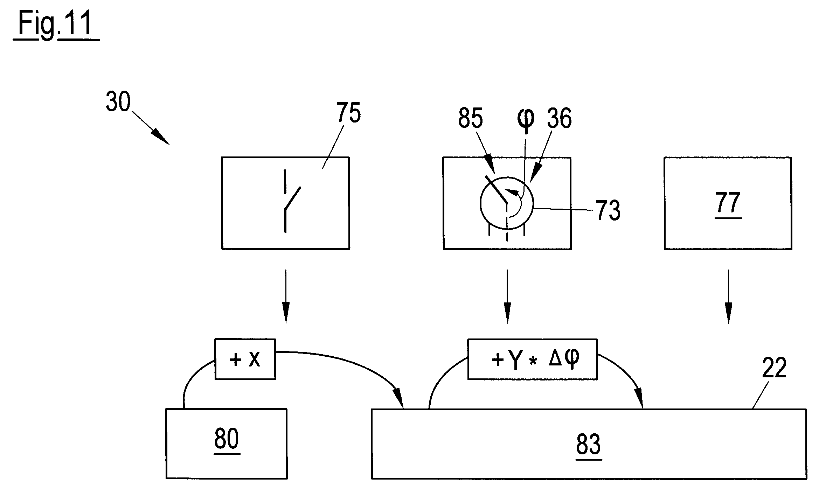

Die durch die Auswerteeinheit 21 (Fig. 1) im Zusammenspiel z. B. mit der Einstellvorrichtung 30 bewirkte Anpassung des Referenzwerts ist in Fig. 11 veranschaulicht. Das Drehpotentiometer 36 weist eine geschlossene Widerstandsbahn 73 auf und ist daher anschlagsfrei endlos drehbar. Ein lediglich als Schaltsymbol dargestellter Taster 75 kann in das Drehpotentiometer 36 integriert sein oder als getrenntes Bauteil ausgeführt sein. Die Einstellvorrichtung 30 umfasst auch eine analoge oder digitale Schnittstelle 77 zum zusätzlichen Anpassen des Referenzwerts anhand eines externen Einstellsignals.

Der aktuelle Referenzwert 83 - z. B. die Schaltschwelle des als Lichttaster ausgeführten Sensors 11 - ist in dem Speicher 22 gespeichert. Bei einem Betätigen des Tasters 75 wird dem aktuellen Messsignal 80 des Lichtempfängers 19 (Fig. 1) ein Sicherheitsabstand x hinzuaddiert und die Summe dann als neuer Referenzwert 83 gespeichert. Es ist auch möglich, vom Hinzuaddieren eines Sicherheitsabstands x abzusehen und/oder eine weitere, komplexe Modifikation des Messsignals 80 vorzunehmen. Bei einem Verdrehen eines Schleifers 85 des Drehpotentiometers 36 wird die Drehstellungsänderung in eine Referenzwert-Änderung umgerechnet und nach Beendigung des Einstellvorgangs zur Anpassung des gespeicherten Werts herangezogen. Das Umrechnen kann mittels einer frei programmierbaren Funktion erfolgen. Mittels einer solchen frei programmierbaren Funktion ist es unter anderem möglich, die Einstellcharakteristik eines Standard-Potentiometers, insbesondere eines 270°-Potentiometers oder eines Mehrgang-Potentiometers, nachzubilden. Wenn z. B. ein Schaltabstand des Sensors zwischen 0 und 100 mm veränderbar ist und ein Umrechnungsfaktor von y = 1 mm / 2,7° festgelegt wird, so entspricht die Schaltabstandsänderung pro Winkeländerung derjenigen eines 270°-Potentiometers. Bei Erreichen der Messbereichsgrenzen, also im vorigen Beispiel bei Erreichen von 0 mm und 100 mm, erfolgt keine weitere Anpassung des Referenzwerts 83 über die betreffende Grenze hinaus. Das heißt es erfolgt keine Verringerung des Referenzwerts 83 auf weniger als 0 mm und auf mehr als 100 mm, unabhängig von einem weiteren Verdrehen des Schleifers 85. Sofern über die Schnittstelle 77 ein neuer Referenzwert 83 ausgegeben wird, so wird dieser direkt gespeichert. Nach jeder Änderung des Referenzwerts 83 mittels des Drehpotentiometers 36 oder über die Schnittstelle 77 wird der aktuelle Drehwinkel ϕ des Schleifers 85 dem geänderten Referenzwert 83 zugeordnet, sodass sich das Drehpotentiometer 36 gewissermaßen stets in Mittelstellung befindet und so eine einfache und präzise Feineinstellung möglich ist.

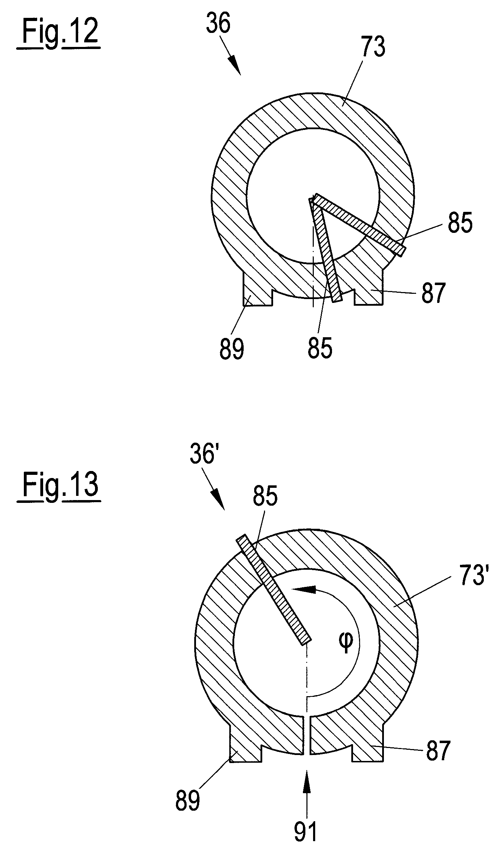

In Fig. 12 ist ein Drehpotentiometer 36 mit einer geschlossenen ringförmigen Widerstandsbahn 73, einem Schleifer 85, einem positiven Bahnkontakt 87 und einem Masse-Bahnkontakt 89 gezeigt. Der Schleifer 85 ist zur Veranschaulichung der Funktionsweise des Drehpotentiometers 36 in zwei verschiedenen Positionen gleichzeitig dargestellt. Es handelt sich hierbei um zwei Positionen, welche aufgrund der vollständig umlaufenden Widerstandsbahn 73 die gleiche Schleiferspannung liefern. Um diese Mehrdeutigkeit zu kompensieren, können verschiedene Maßnahmen getroffen werden, wie nachfolgend unter Bezug auf Fig. 13-18 näher erläutert wird.

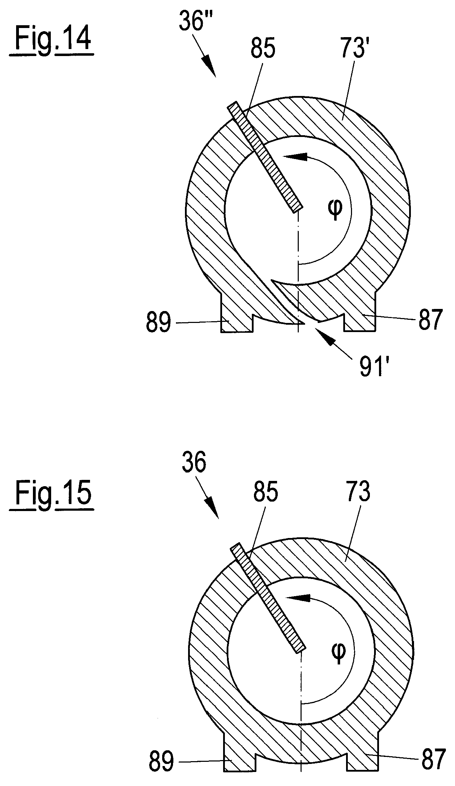

Bei dem in Fig. 13 gezeigten Drehpotentiometer 36' weist die Widerstandsbahn 73' eine schmale Unterbrechung 91 auf. Bei der in Fig. 14 gezeigten Variante eines Drehpotentiometers 36" ist ebenfalls eine schmale Unterbrechung 91' in der Widerstandsbahn 73' vorgesehen, welche hier jedoch nicht radial, sondern schräg verläuft. Der Schleifer 85 überbrückt somit die Unterbrechung 91' immer dann, wenn er sich auf dem bezogen auf den Abstand zwischen positivem Bahnkontakt 87 und Masse-Bahnkontakt 89 kurzen, in Fig. 14 unteren Abschnitt der Widerstandsbahn 73' befindet. Daher kann über eine Strommessung festgestellt werden, auf welcher Seite der Bahnkontakte 87, 89 - in Fig. 14 oben oder untensich der Schleifer 85 befindet.

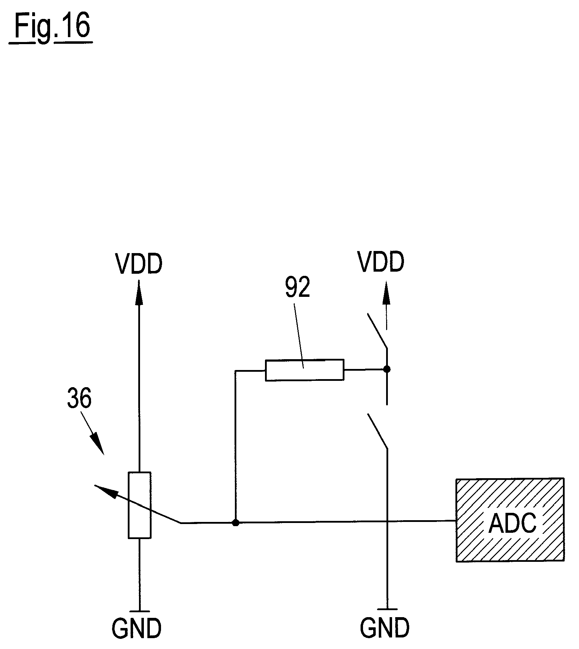

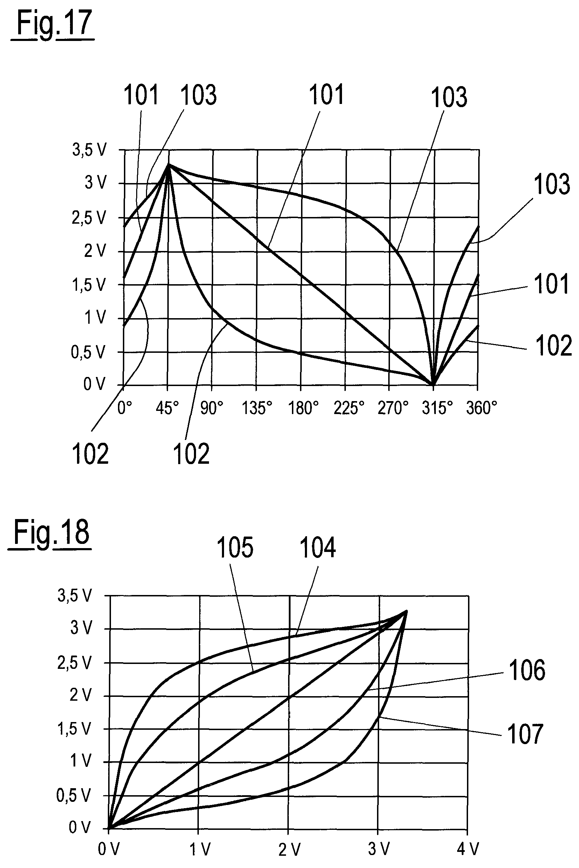

Das in Fig. 15 dargestellte Drehpotentiometer 36 weist eine Widerstandsbahn 73 ohne Unterbrechung auf. Zur Kompensation der vorstehend erwähnten Mehrdeutigkeit ist dem Drehpotentiometer wie in Fig. 16 gezeigt ein schaltbarer Zusatzwiderstand 92 zugeordnet. Anhand eines Vergleichs einer Widerstandsmessung ohne Zusatzwiderstand 92 und mit Zusatzwiderstand 92 kann die Drehstellung des Schleifers 85 eindeutig ermittelt werden, wie nachfolgend unter Bezugnahme auf Fig. 17 und Fig. 18 genauer erläutert wird.

In dem Diagramm gemäß Fig. 17 gibt die mit 101 bezeichnete erste Kurve die Schleiferspannung eines gemäß Fig. 15 gestalteten Drehpotentiometers 36 in Abhängigkeit vom Drehwinkel des Schleifers 85 an. Es ist zu erkennen, dass sich das Drehpotentiometer 36 zwischen 45° und 315° wie ein mit Anschlägen versehenes 270°-Potentiometer verhält. In den Bereichen zwischen 0° und 45° sowie zwischen 315° und 360° befindet sich der Schleifer 85 auf dem unteren Abschnitt der Widerstandsbahn 73 und liefert Schleiferspannungen, die insgesamt zu Mehrdeutigkeiten führen. Eine Messung der Schleiferspannung gegen Masse unter Zuschaltung des Zusatzwiderstands 92 ergibt die zweite Kurve 102, während eine Messung der Schleiferspannung gegen den positiven Bahnkontakt 87 unter Zuschaltung des Zusatzwiderstands 92 die dritte Kurve 103 ergibt. Die Kurven 101, 102, 103 beziehen sich auf ein Ausführungsbeispiel, bei welchem das Drehpotentiometer 36 eine 270°-Bahn mit 100 kOhm und eine 90°-Bahn mit 33 kOhm aufweist, der Zusatzwiderstand einen Widerstandswert von 10 kOhm aufweist und die Versorgungsspannung 3,3 V beträgt. Dem Diagramm ist zu entnehmen, dass anhand der zweiten Kurve 102 und/oder der dritten Kurve 103 eine Zuordnung der Schleiferstellung zu den zwei separaten Abschnitten der Widerstandsbahn 73 möglich ist.

Zur weiteren Erläuterung sind in Fig. 18 die mit Zusatzwiderstand 92 gemessenen Schleiferspannungen für die verschiedenen Bahnabschnitte in Abhängigkeit von der Schleiferspannung ohne Zusatzspannung angegeben. Die vierte Kurve 104 bezeichnet die Schleiferspannung gegen den positiven Bahnkontakt 87 im oberen Abschnitt, die fünfte Kurve 105 bezeichnet die Schleiferspannung gegen den positiven Bahnkontakt 87 im unteren Abschnitt, die sechste Kurve 106 bezeichnet die Schleiferspannung gegen Masse im unteren Abschnitt und die siebte Kurve 107 bezeichnet die Schleiferspannung gegen Masse im oberen Abschnitt. Es ist zu erkennen, dass sich bis zu einer Spannung, die etwa die Hälfte der Versorgungsspannung beträgt, die vierte Kurve 104 und die fünfte Kurve 105 relativ deutlich unterscheiden, während sich bei höheren Spannungen die sechste Kurve 106 und die siebte Kurve 107 relativ deutlich unterscheiden. Dementsprechend sind bei kleinen Spannungen Messungen mit Zusatzwiderstand 92 gegen den positiven Bahnkontakt 87 besser geeignet, während bei höheren Spannungen Messungen mit Zusatzwiderstand 92 gegen Masse zu bevorzugen sind. Das Zuschalten des Zusatzwiderstands 92 kann in einfacher Weise mittels eines Mikrocontrollers durchgeführt werden.

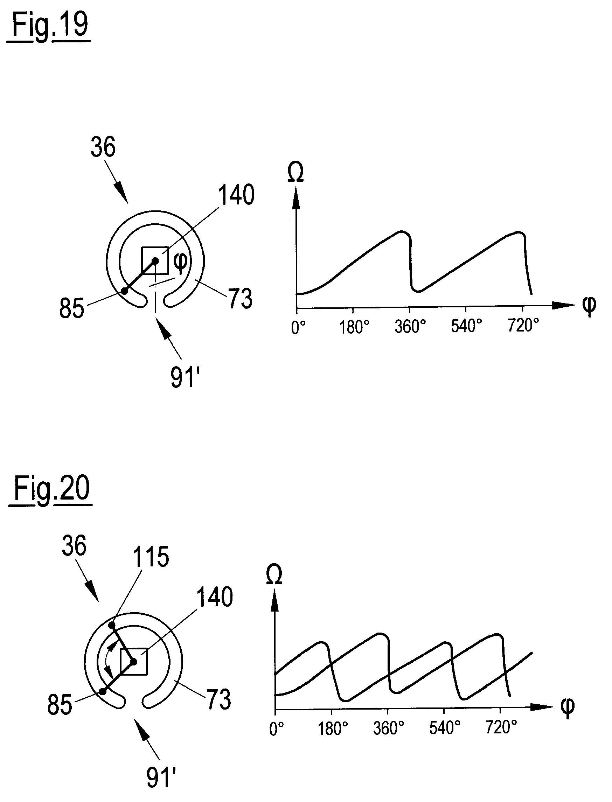

Fig. 19 zeigt ein Drehpotentiometer 36, dessen Widerstandsbahn 73 wie das in Fig. 13 dargestellte Drehpotentiometer 36 eine schmale Unterbrechung 91' aufweist. Aufgrund der Unterbrechung 91' kommt es bei mehrmaligen Umdrehungen des Schleifers 85 zu Sprüngen im Verlauf des abgegriffenen Widerstands, wie aus dem im rechten Teil von Fig. 19 gezeigten Diagramm hervorgeht. Dieser sprungartige Verlauf kann dadurch zumindest abgemildert werden, dass wie in Fig. 20 dargestellt ein weiterer Schleifer 115 vorgesehen wird, welcher bezüglich des ersten Schleifers 85 phasenversetzt - im gezeigten Beispiel um 90° - angeordnet ist. Aufgrund der Überlappung der den beiden Schleifern 85, 115 zugeordenten Einzel-Widerstandsverläufe sind keine ausgeprägten Sprünge im Gesamtverlauf vorhanden.

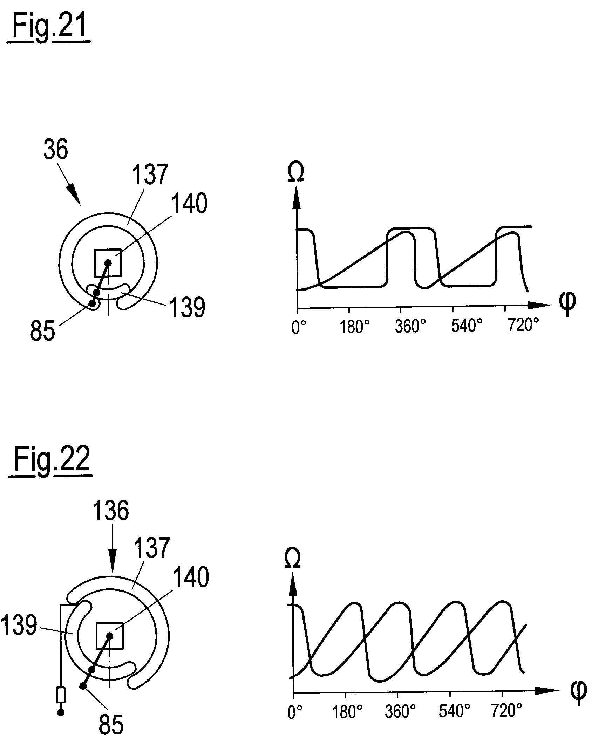

Bei den in Fig. 21 und Fig. 22 gezeigten Ausführungsformen eines Drehpotentiometers 136 sind wenigstens zwei teilweise umlaufende Widerstandsbahnen 137, 139 vorgesehen, welche einander überlappen und so insgesamt einen Winkelbereich von 360° überdecken. Der Schleifer 85 weist dementsprechend mehrere Abgriffe auf. Die in Fig. 19-22 gezeigten Drehpotentiometer 36, 136 sind jeweils mit einem Taster 140 gekoppelt, welcher die Teach-Funktion bereitstellt.

Insgesamt ermöglicht die Erfindung eine besonders einfache, präzise und flexible Anpassung des Schaltabstands eines Lichttasters oder eines anderen die Auswertung betreffenden Referenzwerts eines optoelektronischen Sensors 11.

### Bezugszeichenliste

- 11: optoelektronischer Sensor
- 13: Lichtsender
- 15: Sendelichtstrahlen
- 17: Beleuchtungsbereich
- 18: Empfangslichtstrahlen
- 19: Lichtempfänger
- 21: Auswerteeinheit
- 22: Speicher
- 23: Objekt
- 24: Sensorgehäuse
- 28: Ausnehmung
- 30, 30', 30": Einstellvorrichtung
- 31, 31': Bedienelement
- 33: Druckknopf
- 35: Adapterbauteil
- 36, 36', 36": Drehpotentiometer
- 39: Leiterbahn
- 40: Kontaktstelle
- 41: Lötstelle
- 43A, 43B: Verbindungsbauteil
- 45: leitfähiges Element
- 51: Markierung
- 52: Beschriftung
- 57: Innenseite
- 60: O-Ring
- 61: Drehknopf
- 63: Tastkopf
- 65: Abdeckung
- 67: Leiterplatte
- 69: Verbindungsring
- 70: Schleiferstruktur
- 71: Aussparung
- 73, 73': Widerstandsbahn
- 75: Taster
- 77: Schnittstelle
- 80: aktuelles Messsignal
- 83: Referenzwert
- 85: Schleifer
- 87: positiver Bahnkontakt
- 89: Masse-Bahnkontakt
- 91, 91': Unterbrechung
- 92: Zusatzwiderstand
- 101-107: Kurve
- 115: Schleifer
- 136: Drehpotentiometer
- 137: teilweise umlaufende Widerstandsbahn
- 139: teilweise umlaufende Widerstandsbahn
- 140: Taster

- R: Rotationsachse
- V: Verschiebeachse
- ϕ: Schleiferwinkel

## Patentansprüche

1. Optoelektronischer Sensor (11) zur Erkennung von Objekten (23) oder Objekteigenschaften, insbesondere Lichttaster, umfassend einen Lichtsender (13) zum Aussenden von Sendelichtstrahlen (15) in einen Beleuchtungsbereich (17), einen Lichtempfänger (19) zum Empfangen von Empfangslichtstrahlen (18), und eine Auswerteeinheit (21), die dazu ausgebildet ist, anhand eines von dem Lichtempfänger (19) ausgegebenen Empfängersignals ein in dem Beleuchtungsbereich (17) befindliches oder in diesen hineinragendes Objekt (23) zu erfassen und/oder eine Eigenschaft eines solchen Objekts (23) zu ermitteln, wobei der Auswerteeinheit (21) eine Einstellvorrichtung (30, 30', 30") zum Einstellen eines die Auswertung betreffenden Referenzwerts (83) wie eines Schaltschwellwerts zugeordnet ist, und wobei die Einstellvorrichtung (30, 30', 30") ein drückbares Bedienelement (33, 75, 140) umfasst, mit welchem der Referenzwert (83) auf einen durch das aktuelle Empfängersignal vorgegebenen Einlernwert festlegbar ist,
**dadurch gekennzeichnet, dass**
die Einstellvorrichtung (30, 30', 30") ferner ein um einen Drehwinkel von zumindest 360° drehbares Bedienelement (31, 31') sowie Mittel zum Erfassen der Drehstellung und der Drehstellungsänderung des drehbaren Bedienelements (31, 31') umfasst, wobei die Auswerteeinheit (21) dazu ausgebildet ist, den Referenzwert (83) in Abhängigkeit von der erfassten Drehstellung und/oder der erfassten Drehstellungsänderung anzupassen.

2. Sensor nach Anspruch 1,
**dadurch gekennzeichnet, dass**
das drehbare Bedienelement (31, 31') anschlagsfrei und/oder endlos drehbar ist.

3. Sensor nach Anspruch 1 oder 2,
**dadurch gekennzeichnet, dass**
die Auswerteeinheit (21) eine elektronische Speichereinrichtung (22) zum Ablegen des Referenzwerts (83) aufweist
und/oder
die Auswerteeinheit (21) dazu ausgebildet ist, den Referenzwert (83) bei jeder Drehstellungsänderung des drehbaren Bedienelements (31, 31') zu erhöhen oder zu erniedrigen,
und/oder
die Einstellvorrichtung (30, 30', 30") ferner eine analoge oder digitale Schnittstelle (77) zum zusätzlichen Anpassen des Referenzwerts (83) anhand eines externen Einstellsignals umfasst
und/oder
die Auswerteeinheit (21) dazu ausgebildet ist, nach jedem Drücken des drückbaren Bedienelements (33, 75, 140) und gegebenenfalls nach jeder Änderung des Referenzwerts (83) über eine Schnittstelle (77) die aktuelle Drehstellung des drehbaren Bedienelements (31, 31') dem geänderten Referenzwert (83) zuzuordnen.

4. Sensor nach einem der vorstehenden Ansprüche,
**dadurch gekennzeichnet, dass**
die Auswerteeinheit (21) dazu ausgebildet ist, bei Erreichen einer Messbereichsgrenze des optoelektronischen Sensors (11) das Anpassen des Referenzwerts (83) zu stoppen, selbst wenn das drehbare Bedienelement (31, 31') weiter gedreht wird.

5. Sensor nach einem der vorstehenden Ansprüche,
**dadurch gekennzeichnet, dass**
die Auswerteeinheit (21) dazu ausgebildet ist, bei der Anpassung des Referenzwerts (83) in Abhängigkeit von der erfassten Drehstellung und/oder Drehstellungsänderung die Einstellcharakteristik eines Standard-Potentiometers, insbesondere eines 270°-Potentiometers oder eines Mehrgang-Potentiometers, nachzubilden.

6. Sensor nach einem der vorstehenden Ansprüche,
**dadurch gekennzeichnet, dass**
das drehbare Bedienelement als Drehpotentiometer (36, 36', 36", 136) ausgeführt ist, bevorzugt als ein Drehpotentiometer (36), das eine oder mehrere geschlossene Widerstandsbahnen (73) aufweist, oder als ein Drehpotentiometer (36', 36"), das eine im Wesentlichen ringförmige Widerstandsbahn (73') aufweist, die eine Unterbrechung (91, 91') aufweist, welche eine Breite von höchstens 5% des Bahnumfangs aufweist.

7. Sensor nach Anspruch 6,
**dadurch gekennzeichnet, dass**
das Drehpotentiometer (36', 36") eine im Wesentlichen ringförmige Widerstandsbahn (73') aufweist, die eine Unterbrechung (91, 91') aufweist, welche eine Breite von höchstens 5% des Bahnumfangs aufweist, wobei die Unterbrechung (91') bezogen auf eine Radialrichtung schräg und/oder gekrümmt verläuft.

8. Sensor nach einem der Ansprüche 6 oder 7,
**dadurch gekennzeichnet, dass**
die Einstellvorrichtung (30, 30', 30") einen mit dem Drehpotentiometer (36) in Reihe schaltbaren Zusatzwiderstand (92) aufweist, wobei die oder eine weitere Auswerteeinheit (21) dazu ausgebildet ist, die Drehstellung eines Schleifers (85) des Drehpotentiometers (36) anhand eines Vergleichs einer Widerstandsmessung ohne Zusatzwiderstand und mit Zusatzwiderstand zu ermitteln,
und/oder
das Drehpotentiometer (36) einen ersten Schleifer (85) und einen bezüglich des ersten Schleifers (85) phasenversetzt angeordneten zweiten Schleifer (115) aufweist.

9. Sensor nach einem der Ansprüche 6 bis 8,
**dadurch gekennzeichnet, dass**
das Drehpotentiometer (136) wenigstens zwei teilweise umlaufende Widerstandsbahnen (137, 139) aufweist, welche einander überlappen und so insgesamt einen Winkelbereich von 360° überdecken.

10. Sensor nach einem der Ansprüche 1 bis 5,
**dadurch gekennzeichnet, dass**
das drehbare Bedienelement (31, 31') als mechanischer Drehknopf ausgeführt ist, welcher mit einem Drehwinkelsensor, insbesondere einem HallSensor oder einem Drehwinkelgeber, gekoppelt ist.

11. Sensor nach einem der vorstehenden Ansprüche,
**dadurch gekennzeichnet, dass**
das drückbare Bedienelement (33, 75, 140) und das drehbare Bedienelement (31, 31') als getrennte Bauteile ausgeführt sind.

12. Sensor nach einem der Ansprüche 1 bis 10,
**dadurch gekennzeichnet, dass**
das drückbare Bedienelement (33, 75, 140) in das drehbare Bedienelement (31, 31') integriert ist oder umgekehrt.

13. Sensor nach Anspruch 12,
**dadurch gekennzeichnet, dass**
die Einstellvorrichtung (30, 30', 30") einen Drehknopf (31, 31') aufweist, welcher sowohl drehbar als auch bezüglich einer Drehachse (R) axial verschiebbar in einem Gehäuse (24) des optoelektronischen Sensors (11) gelagert ist.

14. Sensor nach einem der Ansprüche 6 bis 9,
**dadurch gekennzeichnet, dass**
das drehbare Bedienelement (31, 31') über ein Adapterbauteil (35) mit einem Schleifer (85) des Drehpotentiometers (36) gekoppelt ist und zwei an dem Adapterbauteil (35) vorgesehene Kontakte (43A, 43B), welche mit einer Einlernschaltung der Auswerteeinheit (21) verbunden sind, durch eine Leiterfläche (45) des drückbaren Bedienelements (33, 75, 140) überbrückt sind, wenn sich das drückbare Bedienelement (33, 75, 140) in einer gedrückten Endstellung befindet, wobei das Adapterbauteil (35) bevorzugt als Molded Interconnect Device (MID) ausgeführt ist.

15. Sensor nach einem der vorstehenden Ansprüche,
**gekennzeichnet durch**
eine Anzeige, welche die Lage des aktuellen Referenzwerts (83) innerhalb eines Messbereichs des optoelektronischen Sensors (11) kenntlich macht.

## Claims

1. An optoelectronic sensor (11) for recognizing objects (23) or object properties, in particular an optical sensor, comprising a light transmitter (13) for transmitting transmitted light beams (15) into an illuminated zone (17); a light receiver (19) for receiving received light beams (18); and an evaluation unit (21) which is configured to detect an object (23) located in the illuminated zone (17) or projecting into said illuminated zone and/or to determine a property of such an object (23) using a receiver signal output by the light receiver (19), wherein a setting apparatus (30, 30', 30") is associated with the evaluation unit (21) for setting a reference value (83) relating to the evaluation such as a switching threshold value; and wherein the setting apparatus (30, 30', 30") comprises a pressable operating element (33, 75, 140) by which the reference value (83) can be fixed to a value to be taught predefined by the current receiver signal, **characterized in that**
the setting apparatus (30, 30', 30") furthermore comprises an operating element (31, 31') rotatable about an angle of rotation of at least 360° as well as means for detecting the rotational position and the rotational position change of the rotatable operating element (31, 31'), with the evaluation unit (21) being configured to adapt the reference value (83) in dependence on the detected rotational position and/or on the detected rotational position change.

2. A sensor in accordance with claim 1,
**characterized in that**
the rotatable operating element (31, 31') is rotatable free of abutment and/or continuously.

3. A sensor in accordance with claim 1 or claim 2,
**characterized in that**
the evaluation unit (21) has an electronic memory device (22) for storing the reference value (83);
and/or
**in that** the evaluation unit (21) is configured to increase or decrease the reference value (83) on each rotational position change of the rotatable operating element (31, 31');
and/or
**in that** the setting apparatus (30, 30', 30") further comprises an analog or digital interface (77) for the additional adaptation of the reference value (83) using an external setting signal;
and/or
**in that** the evaluation unit (21) is configured to associate the current rotational position of the rotatable operating element (31, 31') with the changed reference value (83) via an interface (77) after every pressing of the pressable operating element (33, 75, 140) and optionally after every change of the reference value (83) .

4. A sensor in accordance with any one of the preceding claims,
**characterized in that**
the evaluation unit (21) is configured to stop the adaptation of the reference value (83) on a reaching of a measured range limit of the optoelectronic sensor (11) even if the rotatable operating element (31, 31') is rotated further.

5. A sensor in accordance with any one of the preceding claims,
**characterized in that**
the evaluation unit (21) is configured to map the setting characteristics of a standard potentiometer, in particular of a 270° potentiometer or of a multi turn potentiometer, during the adaptation of the reference value (83) in dependence on the detected rotational position and/or on the rotational position change.

6. A sensor in accordance with any one of the preceding claims,
**characterized in that**
the rotatable operating element is designed as a rotary potentiometer (36, 36', 36", 136), preferably as a rotary potentiometer (36) which has one or more closed resistive tracks (73) or as a rotary potentiometer (36', 36") which has a substantially annular resistive track (73') which has an interruption (91, 91') which has a width of at most 5% of the track extent.

7. A sensor in accordance with claim 6,
**characterized in that**
the rotary potentiometer (36', 36") has a substantially annular resistive track (73') which has an interruption (91, 91') which has a width of at most 5% of the track extent, with the interruption (91') extending in an oblique and/or curved manner with respect to a radial direction.

8. A sensor in accordance with one of the claims 6 or 7,
**characterized in that**
the setting apparatus (30, 30', 30") has an additional resistor (92) which can be connected in series to the rotary potentiometer (36), with the or a further evaluation unit (21) being configured to determine the rotational position of a slider (85) of the rotary potentiometer (36) using a comparison of a resistance measurement without an additional resistor and with an additional resistor;
and/or
**in that** the rotary potentiometer (36) has a first slider (85) and a second slider (115) arranged phase-delayed with respect to the first slider (85).

9. A sensor in accordance with any one of the claims 6 to 8,
**characterized in that**
the rotary potentiometer (136) has at least resistive tracks (137, 193) which run around partly, which overlap one another and which thus cover an angular range of 360° overall.

10. A sensor in accordance with any one of the claims 1 to 5,
**characterized in that**
the rotatable operating element (31, 31') is configured as a mechanical rotary knob which is coupled to a rotary angle sensor, in particular to a Hall signal or to a rotary encoder.

11. A sensor in accordance with any one of the preceding claims,
**characterized in that**
the pressable operating element (33, 75, 140) and the rotatable operating element (31, 31') are configured as separate components.

12. A sensor in accordance with any one of the claims 1 to 10,
**characterized in that**
the pressable operating element (33, 75, 140) is integrated into the rotatable operating element (31, 31') or vice versa.

13. A sensor in accordance with claim 12,
**characterized in that**
the setting apparatus (30, 30', 30") has a rotary knob (31, 31') which is received both rotatably and axially displaceably with respect to an axis of rotation (R) in a housing (24) of the optoelectronic sensor (11).

14. A sensor in accordance with any one of the claims 6 to 9,
**characterized in that**
the rotatable operating element (31, 31') is coupled to a slider (85) of the rotary potentiometer (36) via an adapter component (35) and two contacts (43A, 43B) which are provided at the adapter component (35) and which are connected to a teaching circuit of the evaluation unit (21) are bridged by a conductor surface (45) of the pressable operating element (33, 75, 140) when the pressable operating element (33, 75, 140) is located in a depressed end position, with the adapter component (35) preferably being configured as a molded interconnect device (MID).

15. A sensor in accordance with any one of the preceding claims,
**characterized by**
a display which identifies the position of the current reference value(83) within a measured zone of the optoelectronic sensor (11).

## Revendications

1. Capteur optoélectronique (11), pour reconnaître des objets (23) ou des propriétés d'objets, en particulier détecteur de lumière, comprenant un émetteur de lumière (13) pour émettre des rayons lumineux d'émission (15) dans une zone d'éclairage (17), un récepteur de lumière (19) pour recevoir des rayons lumineux de réception (18), et une unité d'évaluation (21) qui est réalisée pour détecter un objet (23) se trouvant dans la zone d'éclairage (17) ou faisant saillie dans celle-ci et/ou pour déterminer une propriété d'un tel objet (23) à l'aide d'un signal de réception émis par le récepteur de lumière (19), un dispositif de réglage (30, 30', 30") pour régler une valeur de référence (83) concernant l'évaluation, telle qu'une valeur seuil de commutation, étant associé à l'unité d'évaluation (21) et le dispositif de réglage (30, 30', 30") comprenant un élément-poussoir de manipulation (33, 75, 140) avec lequel la valeur de référence (83) peut être fixée à une valeur d'apprentissage prédéterminée par le signal de réception actuel,
**caractérisé en ce que**
le dispositif de réglage (30, 30', 30") comprend en outre un élément de manipulation (31, 31') rotatif autour d'un angle de rotation d'au moins 360° ainsi que des moyens de détection de la position de rotation et de la modification de position de rotation de l'élément de manipulation (31, 31') rotatif, l'unité d'évaluation (21) étant réalisée pour adapter la valeur de référence (83) en fonction de la position de rotation détectée et/ou de la modification de position de rotation détectée.

2. Capteur selon la revendication 1,
**caractérisé en ce que** l'élément de manipulation (31, 31') rotatif est sans butée et/ou capable de rotation sans fin.

3. Capteur selon la revendication 1 ou 2,
**caractérisé en ce que**
l'unité d'évaluation (21) comprend un dispositif de mémorisation électronique (22) pour déposer la valeur de référence (83), et/ou **en ce que** l'unité d'évaluation (21) est réalisée pour augmenter ou diminuer la valeur de référence (83) à chaque modification de position de rotation de l'élément de manipulation (31, 31') rotatif, et/ou en ce que le dispositif de réglage (30, 30', 30") comprend en outre une interface (77) analogique ou numérique pour adapter additionnellement la valeur de référence (83) à l'aide d'un signal de réglage externe, et/ou en ce que l'unité d'évaluation (21) est réalisée pour, après chaque poussée de l'élément poussoir de manipulation (37, 75, 140) et, le cas échéant, après chaque modification de la valeur de référence (83) via une interface (77), associer la position de rotation actuelle de l'élément de manipulation (31, 31') rotatif à la valeur de référence (83) modifiée.

4. Capteur selon l'une des revendications précédentes,
**caractérisé en ce que**
l'unité d'évaluation (21) est réalisée pour arrêter, lorsqu'une limite de plage de mesure du capteur optoélectronique (11) est atteinte, l'adaptation de la valeur de référence (83) même si l'élément de manipulation (31, 31') rotatif continue à tourner.

5. Capteur selon l'une des revendications précédentes,
**caractérisé en ce que**
l'unité d'évaluation (21) est réalisée pour reproduire, lors de l'adaptation de la valeur de référence (83) en fonction de la position de rotation et/ou de la modification de la position de rotation détectée, la caractéristique de réglage d'un potentiomètre standard, en particulier d'un potentiomètre à 270° ou d'un potentiomètre multi-tours.

6. Capteur selon l'une des revendications précédentes,
**caractérisé en ce que**
l'élément de manipulation rotatif est réalisé sous forme de potentiomètre rotatif (36, 36', 36", 136), de préférence sous la forme d'un potentiomètre rotatif (36) qui présente une ou plusieurs pistes résistives fermées (73) ou sous la forme d'un potentiomètre rotatif (36', 36") qui présente une piste résistive de forme sensiblement annulaire qui présente une interruption (91, 91') qui présente une largeur d'au plus 5 % de la circonférence de la piste.

7. Capteur selon la revendication 6,
**caractérisé en ce que**
le potentiomètre rotatif (36', 36") présente une piste résistive (73') de forme sensiblement annulaire qui présente une interruption (91, 91') qui présente une largeur d'au plus 5 % de la circonférence de la piste, l'interruption (91') s'étendant en oblique et/ou incurvée par rapport à une direction radiale.

8. Capteur selon l'une des revendications 6 ou 7,
**caractérisé en ce que**
le dispositif de réglage (30, 30', 30") présente une résistance additionnelle (92) commutable en série avec le potentiomètre rotatif (36), ladite ou une autre unité d'évaluation (21) étant réalisée pour déterminer la position de rotation d'un curseur (85) du potentiomètre rotatif sur la base d'une comparaison d'une mesure de résistance sans résistance additionnelle et avec résistance additionnelle,
et/ou
le potentiomètre rotatif (36) présente un premier curseur (85) et un deuxième curseur (115) agencé avec décalage de phase par rapport au premier curseur (85).

9. Capteur selon l'une des revendications 6 à 8,
**caractérisé en ce que**
le potentiomètre rotatif (136) présente au moins deux pistes résistives (137, 139) au moins partiellement circonférentielles qui se chevauchent mutuellement et recouvrent ainsi dans l'ensemble une zone angulaire de 360°.

10. Capteur selon l'une des revendications 1 à 5,
**caractérisé en ce que**
l'élément de manipulation (31, 31') rotatif est réalisé sous forme de bouton rotatif mécanique qui est accouplé avec un capteur d'angle de rotation, en particulier un capteur à effet Hall ou un détecteur d'angle de rotation.

11. Capteur selon l'une des revendications précédentes,
**caractérisé en ce que**
l'élément poussoir de manipulation (37, 75, 140) et l'élément de manipulation (31, 31') rotatif sont réalisés en tant que composants séparés.

12. Capteur selon l'une des revendications 1 à 10,
**caractérisé en ce que**
l'élément poussoir de manipulation (37, 75, 140) est intégré dans l'élément de manipulation (31, 31') rotatif ou inversement.

13. Capteur selon la revendication 12,
**caractérisé en ce que**
le dispositif de réglage (30, 30', 30") comprend un bouton rotatif (31, 31') qui est monté aussi bien en rotation que déplaçable axialement par rapport à un axe de rotation (R) dans un boîtier (24) du capteur optoélectronique (11).

14. Capteur selon l'une des revendications 6 à 9,
**caractérisé en ce que**
l'élément de manipulation (31, 31') rotatif est accouplé à un curseur (85) du potentiomètre rotatif (36) via un élément adaptateur (35) et **en ce que** deux contacts (43A, 43B) prévus sur l'élément adaptateur (35), qui sont reliés à un circuit d'apprentissage de l'unité d'évaluation (21), sont mis en court-circuit par une surface conductrice de l'élément poussoir de manipulation (37, 75, 140) lorsque l'élément poussoir de manipulation (37, 75, 140) se trouve dans une position terminale poussée, l'élément adaptateur (35) étant réalisé de préférence sous forme de dispositif d'interconnexion moulé (Molded Interconnect Device - MID).

15. Capteur selon l'une des revendications précédentes,
**caractérisé par**
un affichage qui rend visible la position de la valeur de référence (83) actuelle à l'intérieur d'une plage de mesure du capteur optoélectronique (11).
